Europäisches Patentamt

European Patent Office

Office européen des brevets

(19)

(11) Veröffentlichungsnummer: **0 379 973**
**A1**

(12) # EUROPÄISCHE PATENTANMELDUNG

(21) Anmeldenummer: **90100990.2**

(22) Anmeldetag: **18.01.90**

(51) Int. Cl.⁵: **C23C 14/56**

(30) Priorität: **26.01.89 CH 244/89**

(43) Veröffentlichungstag der Anmeldung:
**01.08.90 Patentblatt 90/31**

(84) Benannte Vertragsstaaten:
**AT BE CH DE DK ES FR GB IT LI LU NL SE**

(71) Anmelder: **BALZERS AKTIENGESELLSCHAFT**

**FL-9496 Balzers(LI)**

(72) Erfinder: **Tischhauser, Reto**
**Hauptstrasse**
**CH-9476 Weite(CH)**

(74) Vertreter: **Scheidegger, Werner & Co.**
**Stampfenbachstrasse 48 Postfach**
**CH-8023 Zürich(CH)**

(54) Schmelzauflage.

(57) Die Schmelzauflage besteht aus einer Vielzahl rostartig nebeneinander angeordneter, durch elektrischen Stromzufluss direkt erhitzbarer Metallstäbe $(1,1',1'')$ von denen zumindest die äusseren $(1',1'')$ zur Bildung einer Seitenwandung gegenüber den anderen Stäben (1) angehoben sind. Die Stabenden sind gemeinsam in einer Ebene durch Metallschrauben (2,3) zusammengehalten.

Die Schmelzauflage wird in Vakuumkammern angeordnet und dient der Aufnahme von zu verdampfendem Schmelzmaterial zu Beschichtungszwecken.

Fig.1

EP 0 379 973 A1

## Schmelzauflage

Die vorliegende Erfindung betrifft eine Schmelzauflage zur Aufnahme von in Vakuumöfen zu verdampfendem Schmelzmaterial, mit einem zur Ablenkung von verdampften Partikeln nach unten im Abstand darüber angeordnetem Reflektor, welche Auflage aus einer Vielzahl unmittelbar nebeneinander angeordneter Metallstäben besteht, deren freie Enden zur Bildung eines elektrischen Anschlusses an eine Stromquelle zusammengehalten sind.

Schmelzauflagen zur Aufnahme von Schmelzmaterial, welche durch direkten Stromdurchgang erhitzt werden, hatten ursprünglich die Form von Tiegeln, d.h. Aufnahmegefässen für das Schmelzmaterial. Es sind Ausführungsformen bekannt, bei denen die Schmelzauflage aus dicht nebeneinander angeordneten Stäben besteht, diese jedoch alle in einer gemeinsamen Ebene liegen. Um Metallpartikel durch Verdampfen zu produzieren und diese Partikel im Vakuumofen von oben nach unten zu lenken, wird oberhalb der Auflage ein Reflektor angeordnet. Die aus der Schmelze austretenden, durch Verdampfung erzeugten Partikel werden zuerst nach oben wegfliegen und am Reflektor nach unten abgelenkt. Die Partikel gelangen durch den Spalt zwischen Schmelzauflage und Reflektoraussenkante nach unten, wo sie schliesslich auf den zu beschichtenden Gegenstand auftreffen.

Die Ausbildung der Schmelzauflage in Form von in einer Ebene aneinandergereihten Stäben mag gewisse Vorteile bezüglich gleichförmiger Erhitzung bringen und erlaubt ein einfaches Einführen des Schmelzmaterials, hat aber den Nachteil, dass nur sehr wenig Schmelzgut aufgelegt werden kann, da sonst die Gefahr besteht, dass die Schmelze seitlich herabtropft.

Bei tiegelartigen Schmelzauflagen besteht andererseits die Gefahr, dass sich der Spalt zwischen Tiegelrand und Reflektor verstopft und zudem Teile des Tiegels verschmelzen. Eine Wiederverwendung der Schmelzauflage war deshalb oft nicht möglich.

Weiter haben bisherige Einrichtungen den Nachteil, dass die seitlich der Schmelzauflage nach unten gelenkten Partikel keine homogene "Wolke" bilden, was zu unregelmässigen Beschichtungen führen kann.

Aufgabe der vorliegenden Erfindung war es, eine neuartige Schmelzauflage zu schaffen, welche einerseits mehrfach verwendet werden kann, ein einfaches Nachfüllen bzw. Nachladen erlaubt und zudem eine weitgehend gleichmässige Verteilung der nach unten gelangenden Partikel mit sich bringt.

Diese Aufgabe wird bei einer Schmelzauflage der eingangs definierten Art erfindungsgemäss dadurch gelöst, dass die einzelnen Stäbe rostartig angeordnet sind und jeweils zumindest die äussersten Stäbe zur Bildung einer Seitenwandung im Bereich zwischen den Endhalterungen gegenüber den anderen Stäben angehoben sind.

Eine bevorzugte Ausführungsform ist derart ausgebildet, dass zwischen den einzelnen Stäben jeweils mindestens über einen Teil der Länge ein Spalt belassen ist, dessen Breite so gewählt ist, dass die Schmelze infolge der Oberflächenspannung nicht durch den Spalt durchfliesst, jedoch verdampfte Partikel direkt durch die rostartige Auflage nach unten dringen.

Um einen einfachen Anschluss an die Stromzuführung zu gewährleisten, sind die Stabenden vorzugsweise jeweils in einer Ebene zusammengehalten.

Die Schmelzauflage kann beispielsweise so ausgebildet sein, dass etwa in der Längsmitte der Stäbe ein querverlaufendes Abstandelement angeordnet ist, welches unterhalb der äusseren Stäbe, jedoch oberhalb der dazwischenliegenden Stäbe verläuft, um so die äusseren Stäbe gegenüber den anderen in angehobener Stellung zu halten.

Beim Erfindungsgegenstand verbleibt die sich bildende Schmelze dank der Oberflächenspannung zwischen Schmelze und Auflagestäben im korbförmigen Behälter, wobei die verdampften Partikel einerseits nach oben und über den Reflektor wieder nach unten in die Beschichtungszone gelenkt werden, andererseits aber auch Partikel durch die rostförmige Auflage, d.h. zwischen den Stäben hindurch direkt nach unten gelangen. Dies führt dazu, dass ein weitgehend homogener Partikelfluss in der Vakuumkammer nach unten zum beschichteten Gegenstand gelangt.

Die Erfindung wird nachstehend anhand eines in der Zeichnung dargestellten Ausführungsbeispiels noch etwas näher erläutert. Es zeigt:

Fig. 1 eine Draufsicht auf eine erfindungsgemässe Schmelzauflage, wobei der Reflektor aus Gründen der besseren Uebersicht lediglich gestrichelt gezeichnet ist;

Fig. 2 eine Seitenansicht der Schmelzauflage nach Fig. 1, und

Fig. 3 einen Querschnitt entlang der Linie III-III von Fig. 2.

Die Zeichnung zeigt eine Schmelzauflage aus einer Vielzahl rostartig nebeneinander angeordneter Stäbe 1,1′,1″, welche hier beispielsweise aus Wolfram (Wo) bestehen. Die Stabenden auf der linken und rechten Seite sind in einer gemeinsamen Ebene durch Metallschuhe 2,3 zusammengehalten, wobei diese Schuhe 2,3 dazu dienen, die Auflage an eine Stromquelle (nicht dargestellt) anzuschliessen. Die Auflage wird durch direkten Stromdurchgang erhitzt, um ein darauf gelegtes Schmelzmaterial, z.B. TiO zu schmelzen und zu verdampfen.

Die ganze Schmelzauflage wird in einer Vakuumkammer angeordnet, und die verdampften Metallpartikel werden zur Beschichtung von ebenfalls in der Vakuumkammer untergebrachten Werkstükken untergebracht.

Der Erfindungsgegenstand dient speziell dem Verdampfen von oben nach unten, d.h. die durch Verdampfen erzeugten Partikel sollen nach unten gegen ein im unteren Teil der Kammer angeordnetes Werkstück gelenkt werden.

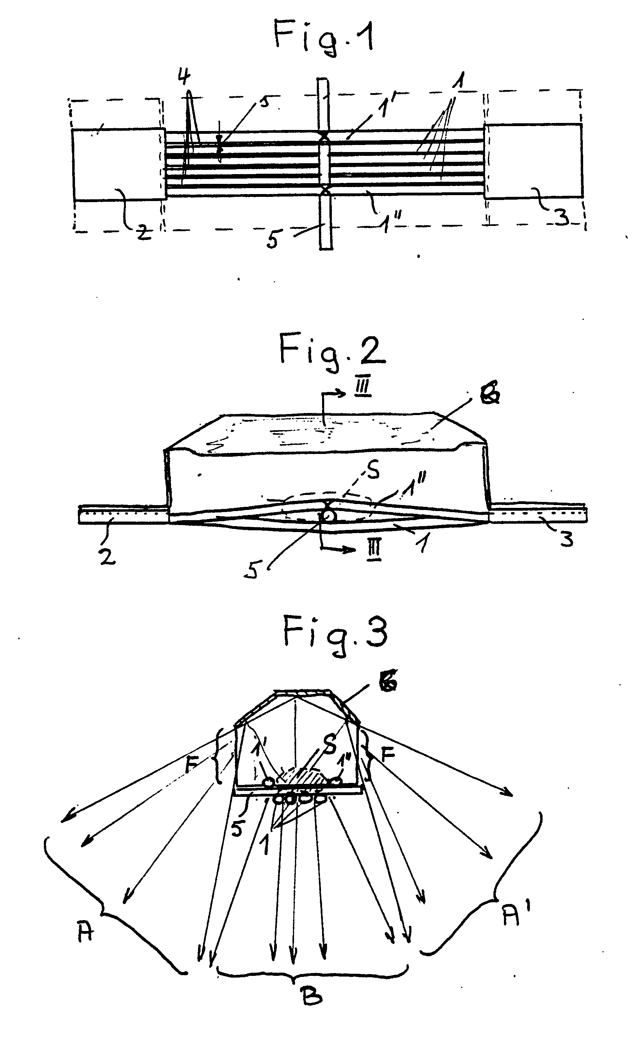

Zu diesem Zweck ist oberhalb der eigentlichen Auflage ein Reflektor 6 angeordnet, welcher die nach oben von der Schmelze S weggeschleuderten Partikel durch die seitlichen Fenster F hindurch nach unten ablenkt. Dabei werden die Partikel etwa in den Bereichen A und A′ (Fig. 3) nach unten gelangen. Dass dabei die Verteilung der Partikel im Raum nicht regelmässig bzw. homogen ausfallen kann, ist klar ersichtlich.

Dank der erfindungsgemässen Ausgestaltung der Auflage, bei welcher die Stäbe 1 rostartig, d.h. mit kleinen seitlichen Spalten 4 zwischen benachbarten Stäben 1 angeordnet sind, können nun aus der Schmelze S Partikel auch zwischen den Stäben hindurch direkt nach unten wegfliegen. Dadurch entsteht ein weiterer, früher nicht abgedeckter Bereich B mit durch Verdampfen gebildeten Partikeln, und die Verteilung der Partikel wird praktisch homogen. Dies führt zu einer wesentlichen Qualitätssteigerung bei den Beschichtungen.

Damit das Schmelzmaterial in der Auflage gehalten ist, sind zudem zumindest die beiden äussersten Stäbe 1′,1″ gegenüber den anderen angehoben, beispielsweise mittels eines in der Längsmitte quer angeordneten Abstandorgans 5. Dieses verläuft oberhalb der Stäbe 1, jedoch unterhalb der äusseren Stäbe 1′,1″ und führt dazu, dass die Auflage eine Art "Korb" oder "Schiffchen" bildet.

Dank der Oberflächenspannung wird die Schmelze S weder zwischen den Stäben 1 noch zwischen den Stäben 1 und den äusseren Stäben 1′ bzw. 1″ hindurch fliessen.

Die gezeigte Konstruktion erlaubt auch das seitliche Einführen neuer Schmelzmaterialchargen (durch die Fenster F). Ein Nachfüllen ist somit problemlos und ohne Ausspannen des Auflagers möglich.

## Ansprüche

1. Schmelzauflage zur Aufnahme von in Vakuumöfen zu verdampfendem Schmelzmaterial, mit einem zur Ablenkung von verdampften Partikeln nach unten im Abstand darüber angeordneten Reflektor, welche Auflage aus einer Vielzahl unmittelbar nebeneinander angeordneten Metallstäben besteht, deren freie Enden zur Bildung eines elektrischen Anschlusses an eine Stromquelle zusammengehalten sind, dadurch gekennzeichnet, dass die einzelnen Stäbe (1,1′,1″) rostartig angeordnet sind und jeweils zumindest die äusseren Stäbe (1′,1″) zur Bildung einer Seitenwandung im Bereich zwischen den Endhalterungen (2,3) gegenüber den anderen Stäben (1) angehoben sind.

2. Schmelzauflage nach Anspruch 1, dadurch gekennzeichnet, dass zwischen den einzelnen Stäben (1,1′,1″) jeweils mindestens über einen Teil der Länge ein Spalt (4) belassen ist, dessen Breite (s) so gewählt ist, dass die Schmelze (S) infolge der Oberflächenspannung nicht durch den Spalt (4) durchfliesst, jedoch verdampfte Partikel (P) direkt durch die rostartige Auflage (1,1′,1″) nach unten dringen.

3. Schmelzauflage nach Anspruch 1, dadurch gekennzeichnet, dass die Stabenden jeweils in einer Ebene zusammengehalten sind.

4. Schmelzauflage nach einem der Ansprüche 1-3, dadurch gekennzeichnet, dass etwa in der Längsmitte der Stäbe (1,1′,1″) ein querverlaufendes Abstandelement (5) angeordnet ist, welches unterhalb der äusseren Stäbe (1′,1″) jedoch oberhalb der dazwischenliegenden Stäbe 1) verläuft, um so die äusseren Stäbe (1′,1″) gegenüber den anderen (1) in angehobener Stellung zu halten.

5. Schmelzauflage nach einem der Ansprüche 1-4, dadurch gekennzeichnet, dass die Metallstäbe (1,1′,1″) und gegebenenfalls das Abstandelement (5) aus Wo-Stäben gebildet sind.

6. Schmelzauflage nach einem der Ansprüche 1-5, dadurch gekennzeichnet, dass der Reflektor (6) als im Bereich (2,3) der Stabenden auf der Auflage abgestützte dachartige Abdeckung ausgebildet ist, wobei diese so angeordnet ist, um zwischen sich und der Auflage (1,1′,1″) an beiden Längsseiten einen der Nachfüllung von Schmelzmaterial und dem Austritt verdampfter Partikel dienenden Spalt (F) zu belassen.

Fig.1

Fig.2

Fig.3

## EINSCHLÄGIGE DOKUMENTE

EP 90100990.2

| Kategorie | Kennzeichnung des Dokuments mit Angabe, soweit erforderlich, der maßgeblichen Teile | Betrifft Anspruch | KLASSIFIKATION DER ANMELDUNG (Int Cl⁵) |
|---|---|---|---|
| A | <u>EP - A1 - 0 024 604</u><br>(A. DE RUDNARY)<br>  * Ansprüche 1,3,4; Fig. 1,2; Seite 11, Zeile 30 - Seite 12, Zeile 10 *<br>-- | 1,5 | C 23 C 14/56 |
| A | <u>DE - B2 - 2 647 011</u><br>(HITACHI LTD.)<br>  * Anspruch 1 *<br>-- | 1 | |
| A | <u>DE - A1 - 3 615 536</u><br>(H. SCHMOOCK)<br>  * Anspruch 1 *<br>---- | 1 | |

| RECHERCHIERTE SACHGEBIETE (Int Cl⁵) |
|---|
| C 23 C 14/00<br>C 23 C  2/00<br>H 05 B  3/00<br>F 27 D  5/00 |

Der vorliegende Recherchenbericht wurde für alle Patentansprüche erstellt.

| Recherchenort | Abschlußdatum der Recherche | Prüfer |
|---|---|---|
| WIEN | 07-05-1990 | PUSTERER |